(19) Europäisches Patentamt
European Patent Office
Office européen des brevets

(11) Publication number: 0 114 876 B1

(12) EUROPEAN PATENT SPECIFICATION

(45) Date of publication of patent specification: 06.06.90

(51) Int. Cl.[5]: C 01 B 33/02

(21) Application number: 83902591.3

(22) Date of filing: 11.07.83

(88) International application number: PCT/US83/01043

(87) International publication number: WO 84/00353 02.02.84 Gazette 84/03

# (54) ULTRA-PURE EPITAXIAL SILICON AND PROCESS FOR ITS MANUFACTURE.

(30) Priority: 12.07.82 US 397445

(43) Date of publication of application: 08.08.84 Bulletin 84/32

(45) Publication of the grant of the patent: 06.06.90 Bulletin 90/23

(84) Designated Contracting States: AT BE CH DE FR GB LI LU NL SE

(56) References cited:
GB-A- 878 764
US-A-2 938 772
US-A-4 279 688

EXTENDED ABSTRACTS, FALL MEETING, 17th-22nd October 1976, Las Vegas, Nevada, vol. 76-2, pages 610-612, abstract no. 234, The Electrochemical Society Inc., US; T.I. KAMINS: "Chemically vapor deposited polycrystalline-silicon films"

IBM TECHNICAL DISCLOSURE BULLETIN, vol. 24, no. 7A, December 1981, pages 3224-3225, New York, US; J.M. BLUM et al.: "Source compounds for CVD silicon depositions"

The file contains technical information submitted after the application was filed and not included in this specification

(73) Proprietor: J.C. SCHUMACHER COMPANY
580 Airport Road
Oceanside California 92054 (US)

(72) Inventor: SCHUMACHER, John C.
4533 Cove Drive, Apt. B
Carlsbad, CA 92008 (US)

(74) Representative: Sommerville, John Henry et al
SOMMERVILLE & RUSHTON 11 Holywell Hill
St. Albans Hertfordshire, AL1 1EZ (GB)

(56) References cited:
EXTENDED ABSTRACTS, FALL MEETING, 17th-22nd October 1976, Las Vegas, Nevada, vol. 76-2, pages 610-612, abstract no. 234, The Electrochemical Society Inc., US; T.I. KAMINS: "Chemically vapor deposited polycrystalline-silicon films"

IBM TECHNICAL DISCLOSURE BULLETIN, vol. 24, no. 7A, December 1981, pages 3224-3225, New York, US; J.M. BLUM et al.: "Source compounds for CVD silicon depositions"

N, Silicon Semiconductor Technology, W.R. Runyan, McGraw-Hill, 1965

EP 0 114 876 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to epitaxial silicon, and specifically to semiconductor grade silicon, and to processes for manufacturing such silicon in the form of a film.

Silicon, as an element, is widely used as a semiconductor material. Semiconductor grade silicon is of extremely high purity and even the most minor impurities can have very dramatic effects upon the semiconductive characteristics of the material and upon potential uses of such silicon. The electrical properties of silicon semiconductor devices are in large part determined by minute amounts of preselected impurities introduced in predetermined amounts into prelocated portions of a semiconcuctor device.

Epitaxial silicon offers the device engineer homogeneously doped single crystal layers with steep concentration gradients between the layers. Epitaxial films are grown in a variety of thicknesses.

| | |
|---|---|
| Thin | 0.5—3 microns |
| Medium | 3—10 microns |
| Thick | 10—20 microns |
| Very thick | >20 microns |

and doping levels

| | |
|---|---|
| Very heavily doped | 0.005—0.1 ohm-cm |
| Heavily doped | 0.1—0.3 ohm-cm |
| Moderately doped | 0.3—1 ohm-cm |
| Lightly doped | 1—10 ohm-cm |

Process difficulty increases considerably at the extreme values of both thickness and resistivity; n-type epitaxy production exceeds p-type by a wide margin.

Device applications include power, small signal discrete, bipolar memory, linear, microwave, imaging, and certain MOS devices. ("Semiconductor Silicon" 1973, ECS Softbound Series, New York 1973).

The critical parameters for epitaxial film include thickness and resistivity, auto-doping and out-diffusion, crystallographic defects, buried layer pattern shift/washout, morphological defects. These parameters are controlled by:

| | |
|---|---|
| Reactor Geometry | Buried Layer preparation technique |
| Reactor Pressure | Growth Rate |
| Method of Heating | Growth Temperature |
| Substrate Orientation | Main Gas Purity |
| Substrate Crystal perfection | Growth Chemicals |

Both silicon homo-epitaxy and silicon hetereo-epitaxy are recognized as well as other epitaxial films.

At atmospheric pressure, epitaxial silicon is grown in a hydrogen atmosphere from four chemicals as noted in Table I.

TABLE I
Epitaxial growth of silicon in hydrogen atmosphere

| Chemical deposition | Normal growth rate | Temperature range | Allowed oxide level |
|---|---|---|---|
| $SiCl_4$ | 0.4—1.5μ/min | 1150—1250°C | 5—10 ppm |
| $SiHCl_3$ | 0.4—2.0 | 1100—1200°C | 5—10 ppm |
| $SiH_2Cl_2$ | 0.4—3.0 | 1050—1150°C | <5 ppm |
| $SiH_4$ | 0.1—0.3 | 950—1050°C | <2 ppm |

The thermodynamics of the $H_2$-Si-Cl system are well characterized. Other silicon halide systems have been studied (E. A. Taft, *J. Electrochem. Soc.*, vol. 118, p. 1535, 1971; L. P. Hunt and E. Sirtl, Abs. No. 270, pp. 672—673, *Extended Abstracts, 72-2*, Electrochem. Soc., New York, 1972; T. Suzuki, M. Ura, T. Ogawa, pp. 191—200, *Proc. Conf. Chem. Vap. Dep., Second Conf.*, J. Block & J. C. Withers, Eds., ECS Softbound Series, Ney York 1972); however, chlorine chemistry is most widely used. HCl impurities have been reported to affect device properties and there are reports of significant reduction of impurities when bromine-based chemicals are used (L. V. Gregor, T. Balik, F. J. Campagna, *IBM J. Res. and Dev.*, vol. 9, p. 327, 1965); however, these benefits have not been realized for most devices in production today.

Epitaxy can be defined as the regularly oriented growth of one crystalline substance on another. The growing crystalling substance is called an "epitaxial film", while the substance upon which the growth occurs is known as the "substrate". If the epitaxial film and the substrate are substances of the same kind, one deals with homoepitaxy, if not, heteroepitaxy. In addition, an epitaxial film can be grown wit material supplied from a liquid phase or vapor phase in contact with the substrate. Thus growth across a solid-liquid interface occurs in liquid-phase epitaxy, while a solid-vapor interface is employed in vapor phase epitaxial growth.

Currently employed commercial processes for vapor phase growth of silicon films are shown in Table II.

TABLE II
Commercial processes

| Source materials | Deposition temperature | Film |
|---|---|---|
| $SiCl_4$, $H_2$ | 1200°C | Epi |
| $SiHCl_3$, $H_2$ | 1150°C | Epi |
| $SiCl_2H_2$, $H_2$ | 1100°C | Epi |
| $SiH_4$, $H_2$ | 1050°C | Epi |
| $SiH_4$, He | 900°C | Epi |
| $SiHCl_3$, $H_2$ | 900—1000°C | Poly |
| $SiH_4$ | 600—700°C (low pressure) | Poly |

The patent document US—A—2938 772 (Enk et al) proposed a method of making extremely pure silicon in the form of rather massive bodies such as a rod or tube by deposition of as much silicon as could efficiently by deposited, at the highest practicable rate, on the inside of a cooler quartz tube. The tube was then broken to recover the tube. The Enk process was designed to grow as much silicon as possible in the shortest possible time. It was produced by decomposing trichlorosilane or tribromosilane at temperatures ranging from 850° to 1150°, using differential heating such that the halogen silane, together with nitrogen, argon or hydrogen as a carrier gas, was gradually raised to the desired temperature while being conducted through the quartz tube.

In *IBM Technical Disclosure Bulletin*, volume 24 No. 7A, December 1981, page 3224, it was suggested that new approaches would be required in the future to methods of growing epitaxial silicon at temperatures below 1000°C. The document comments on closed-tube transport reactions, such as that proposed in the Enk et al document. In particular, it suggests that dopant source compounds needed to be developed to give more uniform doping of, especially, polysilicon layers, and suggests that certain doping compounds might be applicable to chemical vapor deposition processes carried out at atmospheric or low pressure and low temperature with plasma enhancement. Examples of possible dopants are given. The same document suggests that halogen-silicon compounds of the general formula $SiX_aH_{4-a}$, where X is any halogen, may be of especial interest where a=2, for use in open-tube deposition at reduced pressures and temperatures.

According to the present invention in one aspect, epitaxial silicon film is provided which has an undoped resistivity in the inclusive range 10,000 to 25,000 ohm-cm. In general terms, the present invention is concerned with vapor phase epitaxial silicon growth, and is primarily directed at homoepitaxy, although the same principles would apply to heteroepitaxy. In addition, the halosilane compounds, $SiBr_4$, $SiHBr_3$, $SiI_4$ and $SiHI_3$ are used for the purposes of the present invention, as silicon sources in vapor phase growth of epitaxial silicon films due to their unique chemical, physical, thermodynamic, and kinetic properties, as described below.

This invention provides an improved process for producing epitaxial silicon, which operates at a lower temperature and produces higher quality films that do conventional processes at economically useful production rates. The invention is also characterized in that the starting materials are bromosilanes or iodosilanes, and not chlorosilanes.

The process of the invention can be operated without any diluent, whereas a diluent such as $H_2$ or He is *required* in prior art processes. Even if one chose to use a diluent, less diluent would be used than in the prior art chlorosilane processes at corresponding conditions of temperature and growth rate.

An important feature of the invention is the production of much higher quality films than ever before. Up to two orders of magnitude higher resistivity are obtained using this process, with resistivities of up to 25,000 ohm-cm being achieved.

An exemplary embodiment of the invention may be described in terms of starting with $HSiBr_3$, decomposing the $HSiBR_3$ according to the formula given herein at a temperature of about 1050°C in a ratio of 100:1 $H_2$ to $HSiBr_3$, at a growth rate of 200—500 A°/minute, to prdouce epitaxial films of 20,000 to 25,000 ohm-cm resistivity. It is emphasized that the foregoing merely exemplifies and does not limit the invention.

In order to describe the invention at hand, a short description of the physics of chemical vapor deposition is presented which will explain the change of film character from epitaxial to polycrystalline as deposition temperature is lowered with identical source material, as shown in Table II. Chemical vapor deposition (CVD) processes involve a chemical reaction rather than a simple condensation as in physical vapor deposition. For this reason, a necessary but not sufficient condition for initiations of the deposition process is that the Gibbs Free Energy (Δg) be negative for the reaction in question at the temperature and pressure utilized in the process. That is to say, for the chemical reaction

$$SiCl_4+2H_2 \rightarrow Si+4HCl$$

$$\Delta G=\Delta H-T\Delta S<O \text{ at } 1200°C$$

from the process listing presented above. The Gibbs Free Energy represents work which can be obtained from the system if and when the chemical reaction takes place. However, for the reaction to take place, work must be done by the system to create the surface of the new phase (the silicon in the above equation). The total system free energy change can thus only be negative (a precondition to system change) if the work obtained from the chemical reaction is greater than the work done to create the surface of the new phase.

Free Energy is a function of the number of entities contained in a system. Thus,

$$G=\Sigma g_i$$

and

$$\Delta G=\Sigma\Delta g_i$$

so that when each molecule of $SiCl_4$ is converted to Si and HCl, a specific quantity, Δg of work is made available to the system. However, when a silicon phase is formed, work must be expanded to create its surface. This can either be in the form of a spherical surface for homogeneous nucliation of the new phase in the vapor—a sphere has the minimum surface to volume ratio of all shapes of identical volume and therefore requires the minimum work expenditure on creation, or in the form of a surface disk in the case of heterogeneous nucliation of the new phase on a substrate. The following condition is required for homogeneous nucliation to take place:

$$\sum_{i}^{n}\Delta g_1>2\pi r^3(n)g(A)$$

That is to say that since the surface to volume ratio of a sphere decreases as radius increases, a sufficient number of molecules must combine by random fluctuations so that if the change were to occur, more work would be obtained from the chemical change than it would take to create the spherical surface of the new phase. In the case of heterogeneous nucliation the work required for creation of a new surface can be decreased by chemical interaction between the substrate and the atoms of the film grown upon it.

The physical process of random fluctuation gathering of a critical nucleus where

$$\sum_{I}^{n}\Delta g_i>A(r)g(A)$$

is one in which atoms are adsorbed on the surface (adatoms), diffuse along the surface, and then are reevaporated. If a sufficient number of atoms are agglomerated during the surface diffusion process prior to reevaporation, a critical nucleus can be formed and growth can be initiated. Furthermore, if surface diffusion is rapid, and adatom has a higher probability of interacting with a growing nucleus than when surface diffusion rates are low.

Surface diffusion rates are directly dependent upon temperature. Thus, at high temperatures epitaxial growth from a single critical nucleus can occur. As the surface temperature is lowered, however, many nuclii are required for growth and polycrystalline growth takes place. At still lower temperatures so many nuclii occur that no regular crystal array is established, and an amorphous film results. This trend can be seen in Table II.

The halosilane silicon source materials utilized in the practice of the invention described herein, namely $SiBr_4$, $SiHBr_3$, $SiI_4$, and $SiHI_3$ possess the unique characteristic compared to the source materials employed in conventional commercial processes described in the table presented above, of a low propensity for homogeneous nucliation. This fact is demonstrated by US—A—4 318 942, in which

bromosilanes are able to be utilized essentially undiluted in the thermal decomposition reaction

$$4HSiBr_3 \rightarrow Si + 2H_2 + 3SiBr_4$$

to produce semiconductor grade polycrystalline silicon whereas chlorosilane and silane based processes to produce such polycrystalline silicon cannot be carried out without dilution with hydrogen to suppress homogeneous nucliation, the dilution ratio being 20:1 in such a case.

A side effect of the use of hydrogen dilution is that some fraction of the silicon produced occurs via the reaction

$$SiHCl_3 + H_2 \rightarrow Si + 3HCl$$

which is a higher temperature reaction ($\Delta G(t) < O$ at a higher temperature). Thus, hydrogen is added to suppress homogeneous nucliation and results in an increase in reaction temperature. This can also be seen in the commercial process described (Table II) above where epitaxial silicon can be grown from $SiH_4$, at 900° in helium but requires 1050° in hydrogen.

The invention described herein utilizes the named halosilanes to produce at low temperatures (relative), an epitaxial film of silicon via the reactions

$$SiX_4 + 2H_2 \rightarrow Si + 4HX$$

or

$$SiHX_3 + H_2 \rightarrow Si + 3HX$$

or

$$SiX_4 \rightarrow Si + 2X_2$$

or

$$4SiHx_3 \rightarrow Si + 2H_2 + SiX_4$$

Where X is defined as bromine or iodine.

Dilution is required in epitaial growth processes using chloro-compounds to suppress both homogeneous and heterogeneous nucliation and thus to promote growth from a single nuclius. The large size of the Br and I atoms compared to Cl and H, hinder formation of critical nuclii and thus have the same effect as dilution. Thus, dilution can be reduced or eliminated in the process of this invention leading to lower temperatures.

In addition, the Si-Br and Si-I bond energies are lower than the Si Cl bond energy, with the result that $\Delta G(t) < O$ at a lower temperature for the above reactions when X=Br or I compared to X=Cl. This again allows a lower deposition temperature.

Epitaxial film quality is degraded by the presence of interstitial or substitutional impurities or point, line, or volume defects in the crystal lattice known as vacancies, dislocations, or voids. Resistivity, the reciprocal or conductivity, is one measure of film quality since the presence of impurities or crystalline defects decreases resisitivity.

Ultrahigh purity single crystal semiconductor grade silicon grown by the Czrochalski technique conventionally has an undoped resistivity of 25 to 75 ohm-cm. Epitaxial silicon grown from the same conventional source material, e.g., $SiHCl_3$, will show an undoped resistivity of 100 to 250 ohm-cm for high quality source materials, and a clean and leak free reactor. In special cases 1000 ohm-cm can be produced. This is due to:

(1) the absence of impurities leached from the crucible by the melt;

(2) slower growth rates which hold defect densities essentially to equilibrium values;

(3) additional purification during growth by surface reevaporation of impurities prior to inclusion in the growing phase.

The process of the present invention, on the other hand, routinely produced resistivities greater than 10,000 and typically 20,000 to 25,000 ohm-cm.

This quality improvement of the invention stems from a combination of two heretofore unrecognized characteristics of the subject source materials when employed in this application;

(a) improved vapor-liquid partition coefficients compared to chlorosilanes;

(b) higher vapor pressures (lower boiling points) of surface active and multi-energy level impurity metal halides.

The individual vapor-liquid partition coefficients have not been quantified; however, it is possible to obtain overall higher purity source material, with an identical number of distillation plates when bromo- and iodosilanes are utilized instead of the presently employed chlorosilanes. Thus, the source materials utilized in the practice of the present invention will be generally of higher purity than those of commercial processes.

In addition, however, a further purification takes place in the deposition process itself. Metallic impurities will be present as halides, phosphates, or nitrates. Table III presents boiling points of metal

halides showing KCl and $ZnCl_2$ to have higher boiling points and therefore lower vapor pressures than KBr and $ZnBr_2$, respectively. Since the net flux of atoms to a surface can be expressed as

$$\text{J net—J impingement—J evaporation} = \frac{1/3\ P\text{-}Po}{\sqrt{2\pi MkT}}$$

and p(Br)<p(Cl) due to higher purity source material, with $P_o(Br)>P_o(Cl)$ due to the lower boiling point of the bromides and iodides compared to chlorides, the net flux to a surface of metallic impurities will be reduced in the bromo- and iodosilane systems. As a result, fewer impurities will be included in the growing epitaxial film, and higher quality will be achieved.

TABLE III
Boiling points of chloro- and bromohalides

| Metal impurity | Chlorohalide | B.P. °C | Bromohalide | B.P. °C |
|---|---|---|---|---|
| Aluminum 220 ppb | $AlCl_3$ | 1827 | $AlBr_3$ | 268 |
| Calcium<30 ppb | $CaCl_2$ | <1600 | $CaBr_2$ | 810 |
| Chromium 6 ppb | $CrCl_2$ | M.P. 824 | $CrBr_2$ | M.P. 842 |
| | $CrCl_3$ | Subl 1300 | $CrBr_3$ | Subl |
| Copper 13 ppb | $CuCl_2$ | M.P. 498 | $CuBr_2$ | M.P. 498 |
| | | 993d to CuCl | | |
| | $Cu_2Cl_2$ | 1366 | $Cu_2Br_2$ | 1345 |
| Gold<5 ppb | AuCl | 170.0 | AuBr | d 115 |
| Iron 60 ppb | $FeCl_3$ | 315.0 | $FeBr_3$ | subl d. |
| | $FeCl_2$ M.P. | 670 subl | $FeBr_2$ | d 684 |
| Lithium<20 ppb | LiCl | 1360 | LiBr | 1265 |
| Magnesium 13 ppb | $MgCl_2$ | 1412 | $MgBr_2$ | M.P. 700 |
| Mercury<3 ppb | $HgCl_2$ | 304 | $HgBr_2$ | 322 |
| | HgCl | 384 | HgBr | Sub 345 |
| Nickel 4 ppb | $NiCl_2$ | d | $NiBr_2$ | d |
| Potassium 40 ppb | KCl | 1500 | KBr | 1380 |
| Silicon<20 ppb | $SiCl_4$ | 57.6 | $SiBr_4$ | 154.0 |
| Titanium<20 ppb | $TiCl_2$ | — | $TiBr_2$ | M.P. 2900 |
| | $TiCl_3$ | d 440 | $TiBr_3$ | d 400 |
| | $TiCl_4$ | 136.4 | $TiBr_4$ | 230 |
| Zinc<10 ppb | $ZnCl_2$ | 732 | $ZnBr_2$ | 650.0 |
| Arsenic | $AsCl_3$ | 130 | $AsBr_3$ | 221 |
| Sodium<50 ppb | NaCl | 1413 | NaBr | 1390 |

Thus, this invention is characterized as follows:

(1) This invention is an improved epitaxial silicon growth process that operates at lower temperatures

and produces higher quality films than conventional commercial processes at economically useful production rates, through use of bromo- and iodosilanes rather than chlorosilanes or silane. Temperature range 800°C to 1200°C.

(2) The process of this invention can be operated with or without a diluent such as $H_2$ or He but in all cases less diluent is used than with chlorosilanes or silane under identical conditions of temperature and growth rate; e.g., with dilutions of 1 to 100:1, and pressures from vacuum to atmospheric pressure.

(3) Higher quality films, one measure of which is resistivity, are produced. Up to two orders of magnitude greater resistivity is obtained. Resistivity ranges up to 25,000 ohm-cm, or greater.

As one example of this invention, starting from $HSiBr_3$, epitaxial films of 20,000 to 25,000 ohm-cm are obtained at 1050°C, in 100:1 $H_2$ $HSiBr_3$ at 200—500 Angstroms/minute growth rate. Temperatures as low as 800° can be employed by reducing or eliminating the use of a diluent.

This invention is useful in the semiconductor industry to produce semiconductor devices.

**Claims**

1. A process for manufacturing an epitaxial silicon film having a high undoped resistivity of at least 10,000 ohm-cm comprising the steps of: thermally decomposing tribromisilane at a temperature of from 800°C to 1200°C from a reagent feed of tribromosilane at sub-atmospheric pressure of from hydrogen or helium diluted tribromosilane, the dilution ratio being from approximately 1 to 100 parts of hydrogen or helium per part of tribromosilane at the growth rate of silicon atoms of from 200 to 500 angstroms (20—50 nm) per minute as a film of homoepitaxial silicon having a resistivity of at least 10,000 ohm-cm.

2. Epitaxial silicon film having an undoped resistivity in the inclusive range 10,000—25,000 ohm-cm.

3. Epitaxial silicon film according to Claim 2, characterised by an undoped resistivity in the inclusive range 20,000—25,000 ohm-cm.

**Patentansprüche**

1. Verfahren zum Herstellen eines Silizium-Epitaxial-Filmes mit einem ungehemmten Widerstand von wenigstens 10 000 ohm-cm, umfassend die folgenden Verfahrensschritte:
es wirde Tribromisilan bei einer Temperatur von 800—1200° Celsius aus Tribromosilan als Eingangsstoff bei Unterdruck abgebaut, oder aus mit Wasserstoff oder Helium verdünnten Tribromosilan, wobei das Verdünnungsverhältnis etwa 1 bis 100 Teile Wasserstoff oder Helium pro Teil Tribromosilan ist, bei einer Wachstumsrate der Siliziumatome von 200 bis 500 Angström pro Minute als Film aus homoepitaxialem Silizium mit einem Widestand von wenigstes 10 000 ohm-cm.

2. Epitaxialer Siliziumfilm mit einem ungehemmten Widerstand im eingeschlossenen Bereich von 10 000 bis 25 000 ohm-cm.

3. Epitaxialer Siliziumfilm nach Anspruch 2, dadurch gekennzeichnet, daß er einen ungehemmten Widerstand im eingeschlossenen Bereich von 20 000 bis 25 000 ohm-cm aufweist.

**Revendications**

1. Procédé pour fabriquer un film de silicium épitaxial ayant une forte résistivité non dopée d'au moins 10 000 ohm-cm, comportant les étapes consistant à: décomposer thermiquement du tribromosilane à une température de 800°C à 1200°C à partir d'une alimentation en réactif de tribromosilane à une pression inférieure à la pression atmosphèrique, ou à partir de tribromosilane dilué par de l'hydrogène ou de l'hélium à un taux de dilution d'approximativement 1 à 100 parties d'hydrogène ou d'hélium par partie de tribromosilane, à un taux de croissance en atomes de silicium de 200 à 500 angström (20 à 50 nm) par minute sous forme d'un film de silicium homo-épitaxial ayant une résistivité d'au moins 10 000 ohm-cm.

2. Film de silicium épitaxial ayant une résistivité sans dopage comprise entre 10 000 et 25 000 ohm-cm inclusivement.

3. Film de silicium épitaxial selon la revendication 2, caractérisé par une résistivité sans dopage comprise entre 20 000 et 25 000 ohm-cm inclusivement.